(19) Europäisches Patentamt / European Patent Office / Office européen des brevets

(11) **EP 3 438 041 B1**

(12) **FASCICULE DE BREVET EUROPEEN**

(45) Date de publication et mention de la délivrance du brevet:
**13.05.2020 Bulletin 2020/20**

(51) Int Cl.:
**B81B 3/00** *(2006.01)*     **B81C 1/00** *(2006.01)*
**H01S 5/30** *(2006.01)*

(21) Numéro de dépôt: **18186767.2**

(22) Date de dépôt: **01.08.2018**

(54) **STRUCTURE SEMICONDUCTRICE COMPORTANT UNE MEMBRANE SUSPENDUE A PORTION CENTRALE STRUCTUREE EN EPAISSEUR**

HALBLEITERSTRUKTUR DIE EINE AUFGESPANNTE MEMBRAN MIT EINEM IN DER DICKE STRUKTURIERTEN ZENTRALEN ABSCHNITT UMFASST

SEMICONDUCTOR STRUCTURE COMPRISING A SUSPENDED MEMBRANE WITH A THICKNESS-STRUCTURED CENTRAL PORTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.08.2017 FR 1757484**

(43) Date de publication de la demande:
**06.02.2019 Bulletin 2019/06**

(73) Titulaire: **Commissariat à l'Énergie Atomique et aux Énergies Alternatives
75015 Paris (FR)**

(72) Inventeurs:
• **REBOUD, Vincent
  75013 PARIS (FR)**
• **GASSENQ, Alban
  30560 SAINT-HILAIRE (FR)**
• **TARDIF, Samuel
  38100 GRENOBLE (FR)**
• **CALVO, Vincent
  38600 FONTAINE (FR)**
• **TCHELNOKOV, Alexei
  38240 MEYLAN (FR)**

(74) Mandataire: **GIE Innovation Competence Group
310, avenue Berthelot
69372 Lyon Cedex 08 (FR)**

(56) Documents cités:
• **REBOUD V ET AL: "Ultra-high amplified strain on 200 mm optical Germanium-On-Insulator (GeOI) substrates: towards CMOS compatible Ge lasers", PROCEEDINGS OPTICAL DIAGNOSTICS OF LIVING CELLS II, SPIE, US, vol. 9752, 14 mars 2016 (2016-03-14), pages 97520F-97520F, XP060067715, ISSN: 0277-786X, DOI: 10.1117/12.2212597 ISBN: 978-1-5106-1723-0**
• **GASSENQ A ET AL: "1.9% bi-axial tensile strain in thick germanium suspended membranes fabricated in optical germanium-on-insulator substrates for laser applications", APPLIED PHYSICS LETTERS, A I P PUBLISHING LLC, US, vol. 107, no. 19, 9 novembre 2015 (2015-11-09), XP012202293, ISSN: 0003-6951, DOI: 10.1063/1.4935590 [extrait le 1901-01-01]**
• **BURT D ET AL: "Strain-engineering in Germanium membranes towards light sources on Silicon", 2017 IEEE ELECTRON DEVICES TECHNOLOGY AND MANUFACTURING CONFERENCE (EDTM), IEEE, 28 février 2017 (2017-02-28), pages 92-94, XP033106054, DOI: 10.1109/EDTM.2017.7947522**

## Description

### DOMAINE TECHNIQUE

Le domaine de l'invention est celui des structures semiconductrices réalisées en un composé semiconducteur cristallin, et comportant une membrane suspendue dont une portion centrale est mise en tension par des bras tenseurs. L'invention s'applique en particulier aux dispositifs microélectroniques ou optoélectroniques comportant une telle structure semiconductrice.

### ÉTAT DE LA TECHNIQUE ANTÉRIEURE

Dans diverses applications microélectroniques ou optoélectroniques, il peut être avantageux d'utiliser une couche en un composé semiconducteur cristallin, de préférence monocristallin, présentant une contrainte mécanique en tension. C'est le cas notamment de certaines sources de lumière dont le matériau de la couche émissive présente, hors contrainte, une structure de bandes d'énergie indirecte, la structure de bandes étant alors rendue directe par l'application d'une contrainte en tension suffisante. Le composé semiconducteur cristallin peut être un composé à base de germanium, par exemple du germanium, du germanium étain, voire du silicium germanium.

Le document EP2960203 décrit un exemple de structure semiconductrice comportant une couche semiconductrice réalisée à base de germanium, la couche semiconductrice étant structurée pour former une membrane suspendue au-dessus d'une couche support. La membrane suspendue comporte une portion centrale mise en tension par des portions latérales formant des bras tenseurs. Ces derniers présentent une forme trapézoïdale dont la largeur augmente à mesure que l'on s'éloigne de la portion centrale, permettant ainsi d'améliorer l'homogénéité de la distribution spatiale des contraintes mécaniques subies par la portion centrale.

Il existe cependant un besoin de disposer d'une structure semiconductrice à membrane suspendue réalisée en un composé semiconducteur cristallin qui présente des propriétés optiques et/ou électroniques améliorées.

### EXPOSÉ DE L'INVENTION

L'invention a pour objectif de remédier au moins en partie aux inconvénients de l'art antérieur, et plus particulièrement de proposer une structure semiconductrice comportant une membrane suspendue réalisée en un composé semiconducteur cristallin qui présente des propriétés optiques et/ou électroniques améliorées.

Pour cela, l'objet de l'invention est une structure semiconductrice comportant une couche semiconductrice réalisée en un composé semiconducteur cristallin, dont une partie de la couche semiconductrice forme une membrane suspendue au-dessus d'une couche support, la membrane suspendue étant formée : d'une portion centrale contrainte en tension dans un plan parallèle à la couche support ; et de plusieurs portions latérales opposées les unes aux autres vis-à-vis de la portion centrale et agencées de manière à maintenir la portion centrale suspendue et contrainte en tension suivant au moins deux axes distincts de déformation, les portions latérales présentant une largeur moyenne supérieure à une largeur moyenne de la portion centrale. La largeur moyenne est une dimension moyenne, dans un plan parallèle au plan de la couche support, suivant un axe transversal auxdits axes de déformation. Selon l'invention, la portion centrale comporte au moins une zone amincie en épaisseur et le composé semiconducteur cristallin est choisi parmi les éléments de la colonne IV de la classification périodique et les alliages de ces éléments, parmi les alliages comportant des éléments des colonnes III-V de la classification périodique, et parmi les alliages comportant des éléments des colonnes II-VI de la classification périodique.

Certains aspects préférés, mais non limitatifs de cette structure semiconductrice sont les suivants.

La zone amincie peut présenter un amincissement en épaisseur supérieur ou égal à 20%, et de préférence supérieur ou égal à 50%.

Un rapport entre la surface de la zone amincie et celle de la portion centrale peut être supérieur ou égal à 14%, et de préférence être supérieur ou égal à 25%.

La membrane suspendue peut présenter une structure de bandes d'énergie directe au moins dans ladite zone amincie.

Le composé semiconducteur cristallin peut être à base de germanium.

La portion centrale peut comporter une pluralité de zones amincies distinctes les unes des autres et agencées les unes par rapport aux autres de manière à former une cavité optique.

L'invention porte également sur un dispositif optoélectronique d'émission de lumière cohérente comportant une structure semiconductrice selon la caractéristique précédente, la portion centrale étant adaptée à former un milieu à gain du dispositif optoélectronique.

La portion centrale peut comporter une pluralité de zones amincies distinctes les unes des autres et disposées les unes à côté des autres de manière périodique de manière à former des cristaux photoniques.

La portion centrale peut comporter une première zone amincie entourée d'une pluralité de zones amincies distinctes les unes des autres et présentant chacune une forme d'anneau entourant la première zone amincie, de manière à former une cavité optique en anneaux.

La portion centrale peut comporter au moins deux zones amincies sous la forme de bandes parallèles l'une à l'autre s'étendant longitudinalement sur la portion centrale et sur deux portions latérales disposées de manière opposée l'une à l'autre vis-à-vis de la portion centrale. Des miroirs de Bragg peuvent être situés aux extrémités des zones amincies pour former une cavité optique.

L'invention porte également sur un procédé de fabrication d'une structure semiconductrice selon l'une quelconque des caractéristiques précédentes, comportant les étapes suivantes :

i) réalisation d'un empilement formé de la couche semiconductrice recouvrant une couche sacrificielle disposée sur une couche support, la couche semiconductrice présentant une valeur initiale non nulle de contrainte en tension ;
ii) structuration de la couche semiconductrice de manière à former la partie structurée et la partie périphérique ;
iii) réalisation d'au moins une zone amincie en épaisseur dans la portion centrale ;
iv) réalisation d'une cavité sous la partie structurée en rendant libre une surface de la couche support située en regard de la partie structurée, la portion centrale étant alors contrainte en tension à une valeur finale supérieure à la valeur initiale.

Le procédé de fabrication peut comporter au moins les étapes suivantes :

- préalablement à l'étape i de réalisation de l'empilement, on estime une valeur minimale de contrainte en tension à partir de laquelle la zone amincie de la portion centrale présente une structure de bandes d'énergie directe pour une valeur donnée d'épaisseur moyenne de la zone amincie ;
- lors de l'étape i, réalisation de l'empilement de sorte que la couche semiconductrice présente une valeur initiale inférieure à la valeur minimale ;
- préalablement à l'étape ii de structuration, détermination de la structuration de sorte que, après l'étape iv de réalisation de la cavité, la zone amincie de la portion centrale présente une valeur finale de contrainte en tension supérieure ou égale à la valeur minimale, et donc une structure de bandes d'énergie directe.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

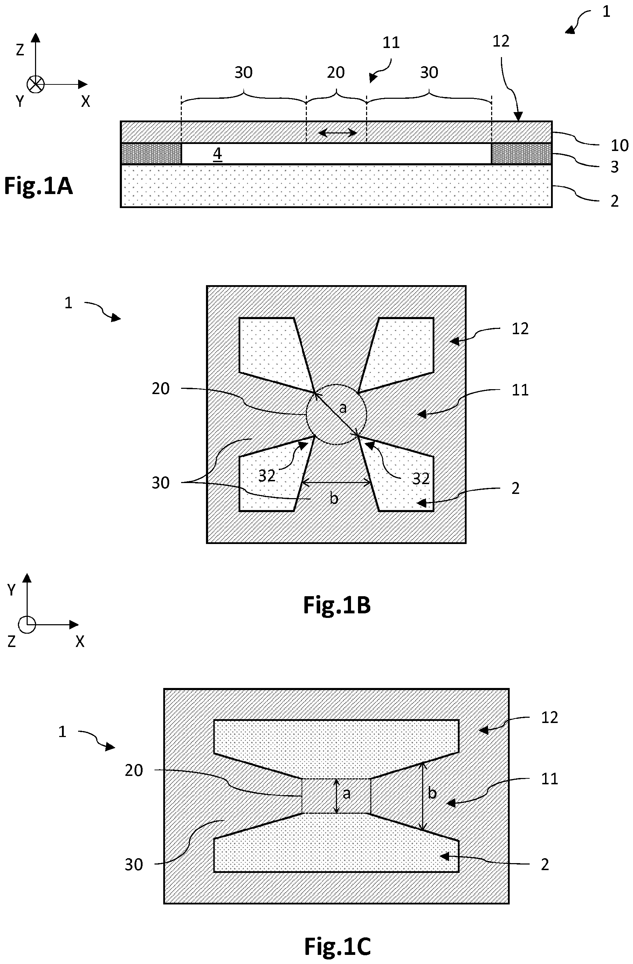

la figure 1A est une vue schématique et partielle en coupe longitudinale d'une structure semiconductrice selon un exemple de l'art antérieur, comportant une membrane suspendue à portion centrale contrainte en tension de manière biaxiale par des bras tenseurs ; la figure 1B est une vue schématique de dessus de la structure semiconductrice illustrée sur la fig.iA ; et la figure 1C est une vue schématique de dessus d'une variante de la structure semiconductrice illustrée sur la fig.1B, dans laquelle la portion centrale est contrainte en tension de manière uniaxiale ;

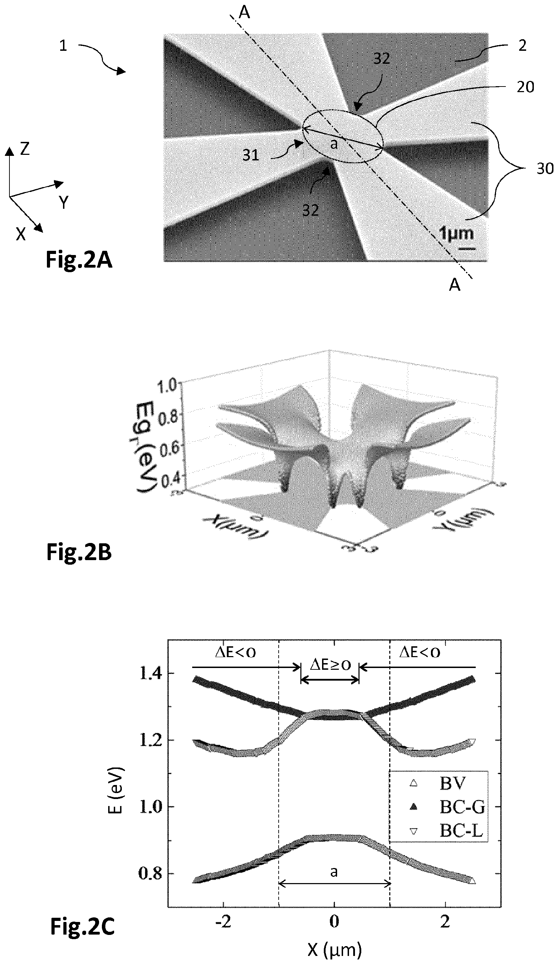

la figure 2A est une vue au microscope électronique à balayage d'une structure semiconductrice similaire à celle illustrée sur la fig.1A ; la figure 2B illustre la distribution spatiale de l'énergie de gap direct $E_{G,\Gamma}$ dans la membrane suspendue de la structure semiconductrice illustrée sur la fig.2A ; et la figure 2C illustre le diagramme de bandes d'énergie de la membrane suspendue suivant l'axe A-A illustré sur la fig.2A ;

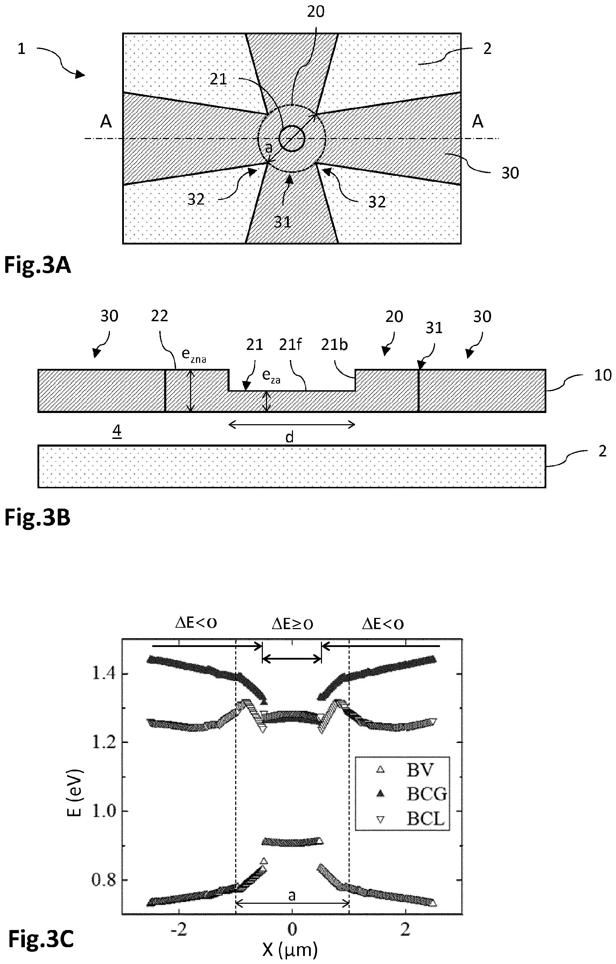

la figure 3A et 3B sont des vues schématiques et partielles, respectivement de dessus et en coupe longitudinale, d'une structure semiconductrice selon un mode de réalisation dans lequel la membrane suspendue comporte au moins une zone amincie en épaisseur, et la figure 3C illustre le diagramme de bandes d'énergie de la membrane suspendue suivant l'axe A-A illustré sur la fig.3A ;

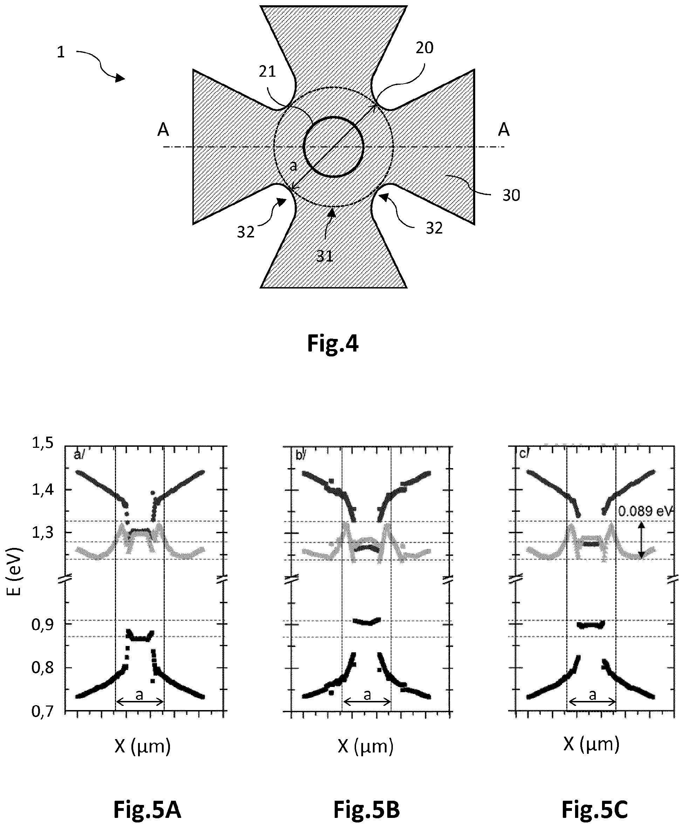

la figure 4 est une vue de dessus, schématique et partielle, d'une structure semiconductrice selon un mode de réalisation dans lequel la membrane suspendue comporte au moins une zone amincie en épaisseur, et les figures 5A à 5C illustrent les diagrammes de bandes d'énergie de la membrane suspendue suivant l'axe A-A illustré sur la fig.4, pour différentes épaisseurs moyennes de la zone amincie ;

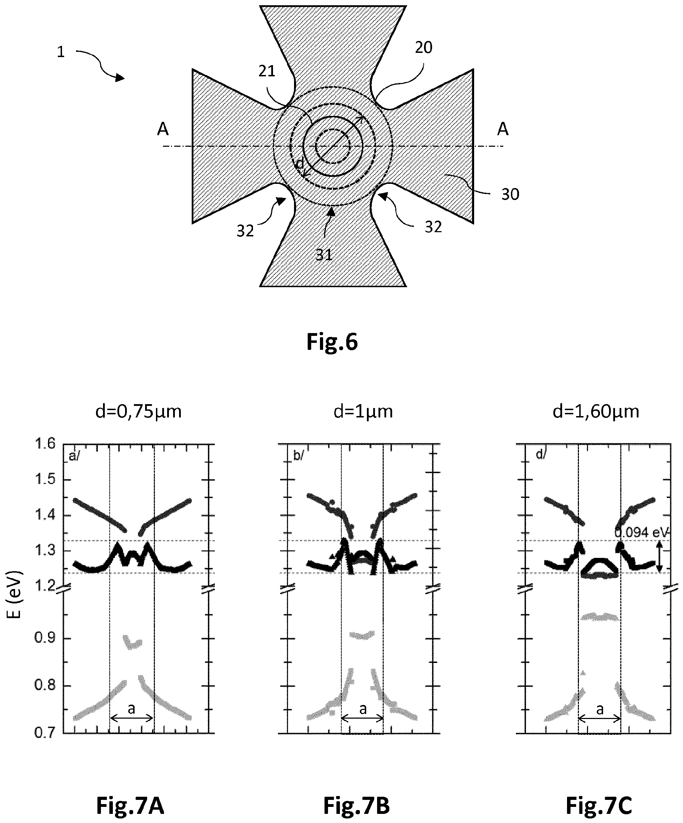

la figure 6 est une vue de dessus, schématique et partielle, d'une structure semiconductrice selon un mode de réalisation dans lequel la membrane suspendue comporte au moins une zone amincie en épaisseur pour différentes surfaces amincies, et les figures 7A à 7C illustrent les diagrammes de bandes d'énergie de la membrane suspendue suivant l'axe A-A illustré sur la fig.4, pour différentes surfaces de la zone amincie ;

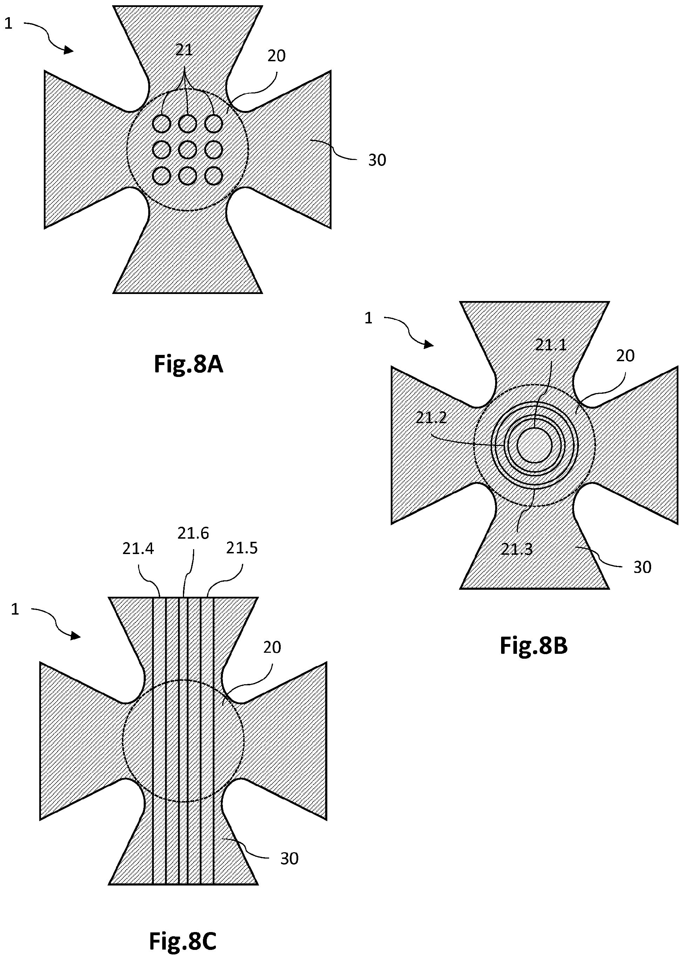

les figures 8A à 8C sont des vues de dessus, schématiques et partielles, de différentes variantes de la structure semiconductrice selon un mode de réalisation comportant une cavité optique à des cristaux photoniques (fig.8A) ; une cavité optique en anneaux (fig.8B) ; et une cavité optique à miroirs de Bragg situés aux extrémités de zones amincies rectilignes (fig.8C).

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près. Par ailleurs, l'expression « comportant un » doit être comprise comme « comportant au moins un », sauf indication contraire.

L'invention concerne d'une manière générale une structure semiconductrice comportant une membrane suspendue réalisée en un composé semiconducteur cristallin, la membrane suspendue comportant une portion centrale mise en tension par des portions latérales formant des bras tenseurs. La membrane suspendue est de préférence réalisée à base de germanium contraint en tension de manière suffisante pour que la portion centrale présente, au moins en partie, une structure de bandes d'énergie directe.

D'une manière générale, le composé semiconducteur cristallin est de préférence monocristallin, et peut être choisi notamment parmi les éléments de la colonne IV de la classification périodique, tels que le silicium, le germanium, l'étain dans sa phase semiconductrice, et les alliages formés de ces éléments, par exemple le SiGe, le GeSn, le SiGeSn. Il peut également être choisi parmi les alliages comportant des éléments des colonnes III et V de la classification périodique, par exemple le GaInAs et l'InP, voire comportant des éléments des colonnes II et VI, par exemple le CdHgTe.

Par portion contrainte, on entend une portion de couche réalisée en un composé semiconducteur cristallin présentant une contrainte mécanique en tension ou en compression, entraînant une déformation des mailles du réseau cristallin du composé semiconducteur. La portion est contrainte en tension lorsqu'elle subit une contrainte mécanique qui tend à étirer les mailles du réseau dans un plan. Dans le cadre de l'invention, la portion centrale de la couche semiconductrice est contrainte en tension dans le plan de la couche, ce qui se traduit par le fait que son paramètre de maille présente une valeur dite effective supérieure à sa valeur dite naturelle lorsque le composé semiconducteur est relaxé, i.e. non contraint. Dans la suite de la description, sauf indication contraire, la contrainte considérée est orientée dans le plan de la couche semiconductrice.

Par structure de bandes directe ou sensiblement directe, on entend que le minimum d'énergie $E_{BC,L}$ de la bande de conduction de la vallée L (ou vallée indirecte) est supérieur ou sensiblement égal au minimum d'énergie $E_{BC,\Gamma}$ de la bande de conduction de la vallée $\Gamma$ (ou vallée directe), autrement dit : $\Delta E = E_{BC,L} - E_{BC,\Gamma} \geq 0$. Par sensiblement égal, on entend ici que cette différence d'énergie est de l'ordre de grandeur ou inférieure à kT, où k est la constante de Boltzmann et T la température du matériau. De préférence, la couche semiconductrice est réalisée à base de germanium dont la structure de bandes d'énergie est indirecte en-dehors de la portion centrale de la membrane suspendue, autrement dit $\Delta E < o$. La portion centrale présente une déformation en tension suffisante pour rendre au moins en partie directe sa structure de bandes d'énergie.

Les figures 1A et 1B sont des vues partielles et schématiques, respectivement en coupe longitudinale et de dessus, d'une structure semiconductrice 1 à membrane suspendue selon un exemple de l'art antérieur dans lequel la portion centrale 20 subit une déformation biaxiale en tension. La figure 1C illustre une variante de structure semiconductrice 1 dans laquelle la déformation en tension de la portion centrale 20 est uniaxiale.

On définit ici et pour la suite de la description un repère direct tridimensionnel (X,Y,Z), où les axes X et Y forment un plan parallèle au plan d'une couche support 2, et où l'axe Z est orienté suivant l'épaisseur des couches. Dans la suite de la description, les termes « inférieur » et « supérieur » s'entendent comme étant relatifs à un positionnement croissant lorsqu'on s'éloigne de la couche support 2 suivant la direction +Z.

La structure semiconductrice 1 comporte un empilement formé d'une couche support 2, d'une couche sacrificielle 3 et d'une couche semiconductrice 10 réalisée en un composé semiconducteur cristallin de préférence monocristallin. La couche support 2 peut être réalisée en un matériau choisi parmi le silicium, le saphir, le borosilicate, la silice, le verre, le quart, ou tout autre matériau adapté. La couche sacrificielle 3 peut être réalisée en un matériau choisi parmi un oxyde ou un nitrure de silicium, entre autres.

La couche semiconductrice 10 est formée d'une partie structurée 11 suspendue au-dessus de la couche support 2 et d'une partie périphérique 12 qui entoure la partie structurée 11. La partie périphérique 12 repose sur la couche sacrificielle 3, celle-ci présentant une cavité 4 située sous la partie structurée 11. La partie structurée 11 comporte une portion centrale 20 reliée à la partie périphérique 12 par des portions latérales 30 formant des bras tenseurs 30. Comme le montrent les figures 1B et 1C, la portion centrale 20 peut présenter une forme, dans le plan (X,Y), sensiblement carrée ou rectangulaire, de quelques centaines de nanomètres à quelques microns de côté, voire une forme circulaire ou polygonale. La couche semiconductrice 10 peut présenter, selon les applications électroniques ou optoélectroniques visées, une épaisseur de l'ordre de quelques dizaines de nanomètres à quelques microns, voire davantage. La couche sacrificielle 3 peut présenter une épaisseur de l'ordre de quelques dizaines de nanomètres à quelques microns. La couche support 2 peut présenter une épaisseur de quelques dizaines de nanomètres à quelques centaines de microns.

Au moins deux portions latérales 30 sont réalisées qui relient chacune une bordure de la portion centrale 20 à la partie périphérique 12. Elles sont agencées deux à deux vis-à-vis de la portion centrale 20 de manière à définir au moins un axe de déformation sensiblement rectiligne. Dans l'exemple de la figure 1B, deux paires de portions latérales 30 sont représentées où ces dernières s'étendent chacune à partie d'une bordure de la portion centrale 20 jusqu'à la partie périphérique 12. Les portions latérales 30 sont agencées deux à deux de manière à définir ici deux axes de déformation, ici respectivement parallèles aux axes X et Y, sécants l'un avec l'autre au niveau de la portion centrale 20. Ainsi, la portion centrale 20 subit une déformation biaxiale en tension suivant les deux axes de déformation. Dans l'exemple de la figure 1C, une unique paire de portions latérales 30 est représentée où ces dernières sont agencées de manière à définir un unique axe de déformation de la portion centrale 20, ici parallèle à l'axe X. Une déformation uniaxiale est alors subie par la portion centrale 20 de la membrane suspendue.

La portion centrale 20 est une portion contrainte, ici en tension, donc présentant une déformation de sa structure cristallographique par augmentation de son paramètre de maille naturel. Les portions latérales 30 permettent d'augmenter la valeur initiale de contrainte en tension dans la portion centrale 20, de préférence sans pour autant subir elles-mêmes une contrainte mécanique significative. Elles forment ainsi des bras tenseurs 30. Pour cela, les bras tenseurs 30 et la portion centrale 20 sont dimensionnés pour que la largeur moyenne « b » des bras tenseurs 30 soit supérieure à la largeur moyenne « a » de la portion centrale 20, de préférence dix fois supérieure à cette dernière.

Par largeur, on entend la dimension d'une portion ou d'un bras, dans le plan (X,Y), suivant un axe transversal, par exemple orthogonal, à son axe longitudinal. La largeur moyenne d'une portion latérale 30 (bras tenseur) peut alors être une moyenne de sa dimension transversale, dans un plan (X,Y) parallèle au plan de la couche support 2, suivant un axe transversal, de préférence orthogonal, à un axe longitudinal de la portion latérale, entre la portion centrale 20 et la partie périphérique 12. Cet axe longitudinal coïncide ici avec un axe de déformation. Dans le cas d'une portion centrale 20 à déformation multiaxiale comme dans l'exemple de la fig.iB, la largeur moyenne « a » de la portion centrale 20 peut être une moyenne de ses dimensions transversales, dans un plan (X,Y) parallèle au plan de la couche support 2, suivant des axes passant par deux jointures 32 diamétralement opposées. Une jointure 32 est une zone dans laquelle deux bras tenseurs adjacents se rejoignent. Il peut ainsi s'agir du diamètre d'un cercle passant de manière tangentielle par les jointures 32. Il peut également s'agir, dans le cas d'une portion centrale 20 de forme sensiblement rectangulaire, de la moyenne entre les distances séparant deux jointures diamétralement opposées ou de la moyenne entre les dimensions du grand axe et du petit axe d'une ellipse passant par les jointures 32.

En outre, la dimension surfacique dans le plan (X,Y), et en particulier la largeur de chaque portion latérale 30, c'est-à-dire la dimension transversale sensiblement orthogonale à l'axe longitudinal, peut être choisie de sorte que la portion latérale 30 ne présente sensiblement pas ou peu de déformation. Plus précisément, la déformation moyenne locale diminue à mesure qu'on s'éloigne de la portion contrainte et devient négligeable à une distance supérieure ou égale à une ou deux fois la dimension de la portion contrainte. La déformation moyenne de la portion latérale 30, c'est-à-dire le champ de déformation intégré dans le volume de la portion latérale 30 présente une valeur inférieure à celle de la portion contrainte, voire est négligeable vis-à-vis de la déformation moyenne dans la portion contrainte. Sur les exemples des figures 1B et 1C, les portions latérales 30 présentent une forme de trapèze de sorte que la largeur augmente continûment à mesure que l'on s'éloigne de la portion centrale 20. D'autres formes sont possibles, par exemple une forme où les portions latérales 30 présentent une augmentation brusque de largeur vis-à-vis de la portion centrale 20 puis une zone principale à largeur constante.

La structuration de la membrane suspendue peut avoir été réalisée de manière à contrôler la valeur de l'amplification de la contrainte en tension de la portion centrale 20, obtenue lors de la réalisation de la cavité 4 et donc de la suspension de la membrane. Pour cela, on prédétermine les paramètres dimensionnels de la partie structurée 11, par exemple les largeurs et longueurs de la portion centrale 20 et des bras tenseurs 30. A titre d'exemple, dans le cas non représenté d'une portion centrale 20 rectangulaire, de longueur A et de largeur constante a, et des bras tenseurs 30 rectangulaires de longueur B/2-A/2 et de largeur constante b, un facteur d'amplification f reliant la contrainte finale $\sigma^f$ en tension de la portion centrale 20 à la contrainte initiale $\sigma^i$ en tension peut s'exprimer par la relation suivante formulée dans l'article de Süess et al intitulé Analysis of enhanced light emission from highly strained germanium microbridges, Nature Photon. 7, 466-472

(2013) :

$$ f = \frac{2L+B}{B}\left(1 + \frac{A}{B-A}\right)\Big/\left(\frac{a}{b} + \frac{A}{B-A}\right) $$

où L est la longueur de la partie structurée 11 suspendue. Ainsi, en fonction des paramètres dimensionnels de la partie structurée 11 de la couche semiconductrice 10, on est en mesure de contrôler la valeur de l'amplification de la contrainte en tension appliquée à la portion centrale 20 lors de la réalisation de la cavité 4. Le facteur d'amplification peut également être estimé au moyen d'un logiciel de simulation numérique tel que COMSOL Multiphysics.

Les figures 2A à 2C illustrent un exemple de l'influence de l'étirement biaxial sur le diagramme de bandes d'énergie de la membrane suspendue d'une structure semiconductrice 1 similaire à celle illustrée sur les fig.iA et 1B.

La figure 2A est une vue au microscope électronique à balayage (MEB) d'une membrane suspendue dans laquelle la portion centrale 20 est étirée de manière biaxiale par quatre bras tenseurs 30 opposés deux à deux. Cette figure est issue de la publication de Gassenq et al. intitulée 1,9% bi-axial tensile strain in thick germanium suspended membranes fabricated in optical germanium-on-insulator substrates for laser applications, Appl. Phys. Lett. 107, 191904 (2015). Dans cet exemple, la membrane suspendue est réalisée en germanium et comporte une portion centrale 20 d'une forme circulaire d'un diamètre « a » de 2$\mu$m environ pour une épaisseur de 600nm environ. La portion centrale 20 subit une déformation moyenne en tension de 1,9% environ par deux paires de bras tenseurs 30 qui étirent la portion centrale 20 suivant des axes de déformation perpendiculaires l'un à l'autre et orientés ici suivant les axes X et Y.

La figure 2B illustre la distribution spatiale de l'énergie de gap direct $\Delta E_\Gamma$ dans la portion centrale 20 et dans une partie des bras tenseurs 30 de la membrane suspendue illustrée sur la fig.2A. L'énergie de gap direct $E_{G,\Gamma}$ est ici définie comme la différence entre l'énergie de la bande de conduction de la vallée directe $\Gamma$ et l'énergie de la bande de valence $E_{G,\Gamma} = E_{BC,\Gamma} - E_{BV}$. Le centre du repère XY est positionné au centre de la portion centrale 20. La figure 2C illustre le diagramme de bandes d'énergie au sein de la membrane suspendue suivant l'axe A-A parallèle à l'axe X passant par la position Y=o. Le diagramme de bandes est obtenu à partir d'un modèle des liaisons fortes, tel que celui décrit dans l'article de Niquet et al. intitulé Onsite matrix elements of the tight-binding Hamiltonian of a strained crystal: Application to silicon, germanium, and their alloys, Phys. Rev. B 79, 245201 (2009).

Les inventeurs ont constaté qu'un étirement uniaxial de la portion centrale 20 de la membrane suspendue, telle que celle illustrée sur la fig.iC, se traduit par une énergie de gap direct $E_{G,\Gamma}$ sensiblement homogène au sens de la portion centrale 20, mais qu'un étirement au moins biaxial entraîne la formation de fortes inhomogénéités de la structure de bandes d'énergie de la portion centrale 20, notamment aux jointures 32 entre les bras tenseurs 30 adjacents.

En effet, alors que dans le cas d'un étirement uniaxial, l'énergie de gap direct $E_{G,\Gamma}$ est homogène au sein de la portion centrale 20, il apparaît que ce n'est plus le cas dans le cas d'un étirement au moins biaxial, comme le montrent les fig.2B et 2C. L'énergie $E_{G,\Gamma}$ prend ainsi une valeur constante de 0,4eV environ sur une distance de 1,5$\mu$m environ centrée sur X=o dans la portion centrale 20 (délimitée sur la fig.2C par des traits pointillés), puis des valeurs qui augmentent fortement notamment en direction des bras tenseurs 30 et des valeurs minimales aux jointures 32 entre les bras tenseurs 30 adjacents (cf. fig.2B). Ainsi, la portion centrale 20 à déformation biaxiale présente une structure de bandes directe $\Delta E > 0$ sur la distance 1,5$\mu$m centrée sur X=o, qui devient ensuite indirecte $\Delta E < 0$ en direction des bras tenseurs 30.

Par ailleurs, il apparaît que l'énergie de gap indirect $E_{G,L}$ ne présente pas une distribution spatiale similaire à celle de $E_{G,\Gamma}$. En effet, elle présente une valeur constante de 0,4eV environ dans une distance de 1$\mu$m environ centrée sur X=o dans la portion centrale 20, qui diminue puis augmente en direction des bras tenseurs 30. Cette variation traduit la présence de puits de potentiel situés aux positions X= $\pm$1,5$\mu$m de part et d'autre de la portion centrale 20, et plus précisément aux jonctions 31 entre la portion centrale 20 et les bras tenseurs 30.

Ainsi, la portion centrale 20 présente une structure de bande directe dans une zone centrale dans la mesure où l'énergie $E_{BC,\Gamma}$ de la bande de conduction de la vallée directe $\Gamma$ est inférieure à celle $E_{BC,L}$ de la vallée indirecte L, mais présente une structure de bande indirecte en direction des bras tenseurs 30. Elle présente également des puits de potentiels formés par la bande de conduction de la vallée indirecte L, ce qui autorise un couplage électronique entre la vallée directe $\Gamma$ et la vallée indirecte L et un piégeage des électrons dans les puits de potentiel.

Ces inhomogénéités de la structure de bandes d'énergie de la membrane suspendue, qui proviennent de la déformation au moins biaxiale de la portion centrale 20, traduisent la présence de fortes variations de l'énergie de gap direct $E_{G,\Gamma}$ ainsi que la présence de puits de potentiel formées par la bande de conduction de la vallée indirecte L, ce qui vient dégrader les performances optiques et/ou électroniques de la membrane suspendue. Ainsi, dans le cas notamment d'une source de lumière cohérente telle qu'une diode laser dont le milieu à gain est formé par la portion centrale 20, ces inhomogénéités sont susceptibles d'entraîner une diminution de l'efficacité d'émission. De plus, des recombinaisons radiatives assistées par phonons peuvent se produire avec de faibles probabilités à partir d'électrons situés dans les puits de potentiel de la vallée indirecte L. Ces transitions radiatives non désirées viennent également dégrader les propriétés optiques et/ou électroniques de la portion centrale 20, par exemple en entraînant un élargissement en longueur d'onde du spectre de photoluminescence de la diode laser.

Les figures 3A et 3B sont des vues partielles et schématiques, respectivement en vue de dessus et en coupe longitudinale suivant l'axe A-A, d'une membrane suspendue selon un mode de réalisation dans laquelle la portion centrale 20 est étirée de manière biaxiale par les bras latéraux et comporte au moins une zone amincie 21 en épaisseur. La figure 3C illustre le diagramme de bandes d'énergie au sein de la membrane suspendue suivant l'axe A-A parallèle à l'axe X passant par la position Y=o.

Les inventeurs ont constaté qu'en structurant la portion centrale 20 en épaisseur, c'est-à-dire en réalisant au moins une zone 21 de la portion centrale 20 qui soit amincie en épaisseur, la membrane suspendue présente des propriétés optiques et/ou électroniques améliorées. Dans la suite de la description, une zone amincie 21 en épaisseur est une zone de la portion centrale 20 dans laquelle l'épaisseur moyenne est inférieure à l'épaisseur moyenne d'une zone non amincie 22. L'épaisseur moyenne est ici la moyenne, par exemple arithmétique, des épaisseurs locales de la portion centrale 20 dans une zone considérée. L'épaisseur moyenne $e_{za}$ de la zone amincie 21 est non nulle, de sorte que la zone amincie 21 ne peut être assimilée à une ouverture traversante de la portion centrale 20. L'épaisseur moyenne $e_{za}$ est de préférence comprise entre 5% et 95% de l'épaisseur non amincie $e_{zna}$ de la couche semiconductrice 10, et de préférence comprise entre 20% et 95%, et de préférence supérieure ou égale à 50%. L'épaisseur non amincie $e_{zna}$ de la portion centrale 20 est sensiblement égale à l'épaisseur moyenne des bras tenseurs 30 et de la partie périphérique 12 de la couche semiconductrice 10.

Ainsi, comme l'illustre la fig.3B, la portion centrale 20 présente au moins une zone non amincie 22 d'épaisseur moyenne $e_{zna}$ et une zone amincie 21 d'épaisseur moyenne $e_{za}$. La zone amincie 21 est entourée au moins en partie, voire entièrement, par une zone non amincie 22. La portion centrale 20 peut comporter une ou plusieurs zones amincies 21, selon les applications microélectroniques ou optoélectroniques de la structure semiconductrice 1. La zone amincie 21 présente une forme, dans le plan XY, circulaire, ovale, polygonale ou autre, et de préférence une forme circulaire pour améliorer la répartition spatiale des contraintes mécaniques. Elle est formée par une surface de fond 21f qui s'étend longitudinalement dans le plan XY et une bordure 21b qui délimite transversalement la surface de fond 21f. La bordure 21b peut s'étendre de manière verticale suivant l'axe Z ou d'une manière inclinée. L'épaisseur moyenne $e_{za}$ de la zone amincie 21 est la distance moyenne, suivant l'axe Z, entre la face inférieure de la portion centrale 20 et la surface de fond 21f. L'amincissement, c'est-à-dire le rapport entre l'épaisseur moyenne $e_{za}$ sur l'épaisseur moyenne $e_{zna}$, peut être supérieur ou égal à 5%, voire à 10% ou 20%, et de préférence supérieur ou égal à 50%. La zone amincie 21 peut présenter une étendue surfacique, dans le plan XY, supérieure ou égale à 5%, voire à 10%, et de préférence à 25%, de la surface de la portion centrale 20. Comme définie précédemment, la surface de la portion centrale 20 peut correspondre à une surface circulaire ou ellipsoïdale dont le périmètre passe par la jointure 32 entre les bras tenseurs 30 adjacents. La surface est ellipsoïdale en particulier lorsque la portion centrale 20 est sensiblement rectangulaire, le grand axe de l'ellipse étant alors orienté suivant la longueur de la portion centrale 20 et le petit axe suivant la largeur.

La figure 3C illustre un exemple de diagramme de bandes d'énergie pour une portion centrale 20 à zone amincie 21, suivant l'axe X à la position Y=o. Dans cet exemple, la membrane suspendue est réalisée à base de germanium et ici plus précisément en germanium, et la portion centrale 20 présente une forme sensiblement circulaire d'un diamètre « a » de 2μm environ, et comporte une zone amincie 21 de 1μm de diamètre. La portion centrale 20 présente une déformation moyenne en tension de 2,3% environ dans la zone amincie 21, supérieure à la déformation en tension de 1,9% mentionnée précédemment du fait de la présence de la zone amincie 21. La portion centrale 20 présente une épaisseur moyenne $e_{zna}$ de 600nm environ, et l'épaisseur moyenne $e_{za}$ de la zone amincie 21 est de 300nm environ (amincissement de 50% en épaisseur).

Il en résulte que la portion centrale 20 garde une structure de bandes directe autour de (X,Y)=(o,o), et en particulier dans la zone amincie 21, dans la mesure où l'énergie $E_{BC,\Gamma}$ de la bande de conduction de la vallée directe $\Gamma$ est localement inférieure à celle $E_{BC,L}$ de la vallée indirecte L. Par ailleurs, le diagramme de bandes d'énergie de la membrane suspendue présente des barrières de potentiel situées autour de la zone amincie 21 et en particulier aux jonctions 31 entre la portion centrale 20 et les bras tenseurs 30, ici à X=±0,75μm, qui permettent d'améliorer le confinement des électrons dans la portion centrale 20, et en particulier dans la zone amincie 21, réduisant ainsi le risque de couplage électronique de la vallée directe $\Gamma$ vers la vallée indirecte L et donc le piégeage d'électrons dans les puits de potentiel décrits précédemment. Il en ressort que les propriétés optiques et/ou électroniques de la membrane suspendue sont donc améliorées par la présence de barrières de potentiel autour de la zone amincie 21. Ainsi, dans le cas où la portion centrale 20 forme le milieu à gain d'une source de lumière cohérente telle qu'une diode laser, l'efficacité d'émission peut être fortement améliorée.

La figure 4 et les figures 5A à 5C illustrent l'influence de la valeur de l'épaisseur moyenne $e_{za}$ de la zone amincie 21 sur la structure de bandes d'énergie de la membrane suspendue. La fig.4 est une vue de dessus de la portion centrale 20 et des portions latérales 30 de la membrane suspendue dans le cas d'une tension biaxiale, et les fig.5A à 5C illustrent le diagramme de bandes d'énergie de la membrane suspendue suivant l'axe A-A parallèle à l'axe X et passant par la position Y=o, pour des amincissements respectifs de 20%, de 50% et de 80%.

Dans cet exemple, le composé semiconducteur cristallin est réalisé à base de germanium, et est ici du germanium, et la portion centrale 20 présente une surface sensiblement circulaire d'un diamètre « a » de 2μm environ, pour une épaisseur moyenne non amincie $e_{zna}$ de 600nm environ et une déformation moyenne en tension de 2,3% environ dans la zone amincie 21. Elle comporte une zone amincie 21 de forme sensiblement circulaire d'un diamètre de 1μm environ, positionnée ici à égale distance des bras tenseurs 30. L'épaisseur $e_{za}$ de la zone amincie 21 est égale à 480nm environ dans le cas de l'amincissement de 20%, à 300nm environ pour 50% d'amincissement, et à 120nm environ pour 80% d'amincissement.

Comme l'illustrent les fig.5A à 5C, la portion centrale 20 présente une structure de bandes sensiblement directe autour de $(X,Y)=(o,o)$, et en particulier dans la zone amincie 21, pour chacun des amincissements de 20%, 50% et 50%, dans la mesure où l'énergie $E_{BC,\Gamma}$ de la bande de conduction de la vallée directe $\Gamma$ est localement égale ou inférieure à celle $E_{BC,L}$ de la vallée indirecte L. Elle est quasi-directe pour l'amincissement de 20% dans la mesure où la différence $\Delta E$ entre $E_{BC,L}$-$E_{BC,\Gamma}$ est négative, mais reste faible, c'est-à-dire inférieure à 0.01eV, correspondant à kT pour T=120K. Elle est directe pour les amincissements de 50% et 80% dans la mesure où $\Delta E$ est positif.

Par ailleurs, quelle que soit la valeur des amincissements, l'énergie $E_{BC,L}$ de la bande de conduction de la vallée indirecte L présente des barrières de potentiel situées autour de la zone amincie 21 et en particulier à la jonction 31 entre la portion centrale 20 et les bras tenseurs 30. L'amincissement peut être de 50% environ ou plus, de manière à augmenter la valeur des barrières de potentiel à 89meV environ, améliorant ainsi encore le confinement des électrons dans la portion centrale 20, et diminuant davantage le risque de couplage entre la vallée directe $\Gamma$ et la vallée indirecte L et donc le risque de piégeage des électrons dans les puits de potentiel. Par ailleurs, il apparaît également que les valeurs $\Delta E$ entre $E_{BC,L}$- $E_{BC,\Gamma}$ se réduisent à partir de l'amincissement de 50% car la déformation en tension augmente au centre de la membrane. Il en ressort que les propriétés optiques et/ou électroniques sont améliorées en particulier lorsque l'amincissement est supérieur ou égal à 20%, et davantage lorsqu'il est supérieur ou égal à 50%.

La figure 6 et les figures 7A à 7C illustrent l'influence de la surface de la zone amincie 21 sur la structure de bandes d'énergie de la membrane suspendue. La fig.6 est une vue de dessus de la portion centrale 20 et des portions latérales 30 de la membrane suspendue dans le cas d'une tension biaxiale pour différentes surfaces de la zone amincie 21, et les fig.7A à 7C illustrent le diagramme de bandes d'énergie de la membrane suspendue suivant l'axe A-A parallèle à l'axe X passant par la position Y=o, pour une surface de la zone amincie 21 respectivement de 14%, 25% et 64% de la surface de la portion centrale 20.

Dans cet exemple, le composé semiconducteur cristallin est du germanium. On considère une portion centrale 20 de surface sensiblement circulaire d'un diamètre « a » de $2\mu m$ environ, d'épaisseur moyenne non amincie $e_{zna}$ de 600nm environ, et de déformation en tension de 2,3% environ dans la zone amincie 21. Elle comporte une zone amincie 21 de forme sensiblement circulaire positionnée ici à égale distance des bras tenseurs 30, d'une épaisseur moyenne $e_{za}$ de 300nm (amincissement de 50%). Trois diamètres « d » de zone amincie 21 sont décrits : 650nm, $1\mu m$, et $1,6\mu m$, correspondant respectivement à 14%, 25% et 64%.

Comme l'illustrent les figures 7A à 7C, plus la zone amincie 21 présente une surface importante, plus la structure de bandes y est directe. En effet, à mesure que la surface de la zone amincie 21 augmente, la différence $\Delta E$ entre $E_{BC,L}$- $E_{BC,\Gamma}$ dans la zone amincie 21, est positive et devient plus importante. De plus, l'énergie $E_{BC,L}$ de la bande de conduction de la vallée indirecte L présente des barrières de potentiel autour de la zone amincie 21, situées en particulier à la jonction 31 entre la portion centrale 20 et les bras tenseurs 30. Pour une surface de zone amincie 21 égale à au moins 25% de la surface de la portion centrale 20, les barrières de potentiel présentent une valeur égale à 94meV environ, améliorant ainsi davantage le confinement des électrons dans la zone amincie 21 de la portion centrale 20, ce qui permet de réduire encore le risque de couplage électronique entre la vallée directe $\Gamma$ et la vallée indirecte L et donc le risque de piégeage des électrons dans les puits de potentiel. Par ailleurs, il apparaît également que la bande de conduction de la vallée directe $\Gamma$ et la bande de valence présentent des valeurs sensiblement constantes dans la zone amincie 21 à partir d'un rapport des surfaces supérieur ou égal à 25%, ce qui contribue à améliorer les propriétés optiques et/ou électroniques de la membrane suspendue. Il en ressort que les propriétés optiques et/ou électroniques sont améliorées, en particulier lorsque le rapport de la surface de la zone amincie 21 sur celle de la portion centrale 20 est supérieur ou égal à 25%.

Un procédé de fabrication de la structure semiconductrice 1 selon le mode de réalisation illustré sur la fig.2A est maintenant décrit. Ce procédé est similaire à celui décrit dans la demande de brevet EP3151265. La couche semiconductrice 10 est, dans cet exemple, réalisée en germanium monocristallin.

Lors d'une première étape, on réalise un empilement formé de la couche semiconductrice 10 en germanium, solidarisée à la couche support 2 par l'intermédiaire de la couche sacrificielle 3. La couche support 2 est, dans cet exemple, en silicium et la couche sacrificielle 3 est en oxyde de silicium. La couche semiconductrice 10 présente une valeur initiale non nulle $\sigma^i$ de contrainte mécanique en tension.

Pour cela, on réalise ici l'empilement sous forme d'un substrat GOI (pour *Germanium On Isulator*, en anglais), c'est-à-dire d'une couche semiconductrice 10 de germanium recouvrant la couche sacrificielle 3 d'oxyde de silicium reposant ici sur la couche support 2 de silicium. Cet empilement est de préférence réalisé au moyen du procédé décrit dans la publication de Reboud et al. intitulée Structural and optical properties of 200 mm germanium-on-insulator (GeOI) substrates for silicon photonics applications, Proc. SPIE 9367, Silicon Photonics X, 936714 (February 27, 2015) qui met notamment en œuvre la technologie Smart Cut™.

De manière alternative, on peut réaliser l'empilement par croissance épitaxiale d'une couche semiconductrice 10 de germanium sur un substrat, la couche semiconductrice 10 de germanium étant ensuite recouverte d'une couche d'oxyde de silicium. On solidarise cet empilement par collage moléculaire avec un second empilement formé d'une couche de silicium recouverte d'une couche d'oxyde de silicium, le collage étant réalisé par mise en contact mutuel des couches d'oxyde de silicium. On supprime ensuite totalement le substrat, par exemple par meulage (*grinding*, en anglais), de manière à obtenir ainsi la couche semiconductrice 10 en germanium liée à une couche support 2 de silicium par une couche sacrificielle 3 d'oxyde de silicium. Cette approche est notamment décrite dans la publication de Jan et al. intitulée Tensile-strained germanium-on-insulator substrate for silicon-compatible optoelectronics, Opt. Mater. Express 1, 1121-1126 (2011).

La réalisation de la couche semiconductrice 10 d'épaisseur voulue $e_{zna}$ au moyen du procédé décrit dans la publication de Reboud et al. 2015 est particulièrement avantageuse dans la mesure où la qualité cristalline de la couche semiconductrice 10 est alors particulièrement élevée et sensiblement homogène suivant l'épaisseur de la couche. A titre d'exemple, la densité de dislocations peut être inférieure à $10^7$ cm$^{-2}$ sur toute l'épaisseur de la couche, en particulier au niveau de l'interface avec la couche sacrificielle 3.

Lors d'une deuxième étape, on réalise la structuration de la couche semiconductrice 10 de manière à former la partie structurée 11 et la partie périphérique 12. La partie structurée 11 comporte une portion centrale 20 subissant une déformation en tension suivant au moins deux axes de déformation définis par les bras tenseurs 30. La partie structurée 11 est réalisée par des étapes classiques de lithographie puis de gravure de la couche semiconductrice 10. La partie structurée 11 subit encore, à cette étape, la contrainte en tension initiale $\sigma^i$.

Lors d'une troisième étape, on réalise au moins une zone amincie 21 en épaisseur située dans la portion centrale 20. Plusieurs zones amincies 21 peuvent être formées en fonction des applications microélectroniques ou optoélectroniques de la structure semiconductrice 1. La zone amincie 21 est réalisée par des étapes classiques de lithographie et de gravure. Elle présente une forme dans le plan XY qui dépend également des applications visées. Son épaisseur est de préférence comprise entre 5% et 95% de l'épaisseur non amincie de la couche semiconductrice 10, et de préférence comprise entre 20% et 95%, voire de préférence comprise entre 50% et 80%. Pour faciliter la gravure partielle, la couche semiconductrice 10 peut être formée d'un empilement de sous-couches en des matériaux distincts, par exemple à base de germanium, dont l'une forme une couche d'arrêt de gravure. A titre d'exemple, la sous-couche d'arrêt de gravure peut être réalisée en germanium étain GeSn et la sous-couche supérieure gravée localement être en germanium. Le germanium sera gravé sélectivement par tétrafluorure de carbone ($CF_4$) avec arrêt de gravure sur le germanium étain. Par ailleurs, lors de la réalisation de la couche semiconductrice 10, des zones dopées peuvent être formées dans les bras tenseurs 30 en regard l'un de l'autre, et des puits quantiques peuvent être formés dans la portion centrale 20.

Lors d'une quatrième étape, on réalise une cavité 4 sous la partie structurée 11 de la couche semiconductrice 10 en rendant libre une surface de la couche support 2 située en regard de la partie structurée 11, de manière à suspendre la partie structurée 11 au-dessus de la couche support 2. Les contraintes en tension présentent dans les portions latérales 30 relaxent, de sorte que la portion centrale 20 subit alors une contrainte en tension d'une valeur finale $\sigma^f$ supérieure à la valeur initiale $\sigma^i$. Les portions latérales 30 jouent alors un rôle de bras tenseurs 30. Pour cela, la cavité 4 peut être réalisée par gravure humide de la couche sacrificielle 3 rendue accessible par des ouvertures obtenues lors de la structuration de la couche semiconductrice 10. La gravure humide peut utiliser ici de l'acide fluorhydrique (également appelé HF, pour *Hydrogen Fluoride* en anglais) en phase vapeur.

On obtient ainsi une structure semiconductrice 1 à membrane suspendue, dont la portion centrale 20 subit une mise en tension augmentée par les bras tenseurs 30 lors de la suspension. La présence d'au moins une zone amincie 21 en épaisseur dans la portion centrale 20 permet d'améliorer les propriétés optiques et/ou électroniques de la membrane suspendue, dans la mesure où le diagramme de bandes montre la présence de barrières de potentiels situés autour de la zone amincie 21 et en particulier entre la portion centrale 20 et les bras tenseurs 30, ces barrières de potentiel améliorant le confinement électronique dans la zone amincie 21 de la portion centrale 20 et réduisant les risques de piégeages des électrons dans des puits de potentiels formés par la bande de conduction de la vallée indirecte L.

Comme le décrit la demande de brevet EP3151265, pour s'assurer que la suspension de la membrane permet d'obtenir une structure de bandes d'énergie directe dans la portion centrale 20 et en particulier dans la ou les zones amincies 21, on peut estimer au préalable une valeur minimale $\alpha^{min}$ de contrainte en tension à partir de laquelle la zone amincie 21, d'épaisseur $e_{za}$ et de surface données, présente une structure de bandes directe. On réalise ensuite l'empilement de sorte que la couche semiconductrice 10 présente une valeur initiale $\sigma^i$ inférieure à la valeur minimale $\alpha^{min}$, puis on structure la portion centrale 20 et les bras tenseurs 30 de sorte que, après suspension de la membrane, la portion centrale 20 présente une valeur finale $\sigma^f$ de contrainte en tension supérieure ou égale à la valeur minimale $\sigma^{min}$, et donc une structure de bandes d'énergie directe dans la ou les zones amincies 21 de la portion centrale 20. La structuration de la partie structurée 11 peut être effectuée à partir de la relation donnée dans l'article de Süess 2013 mentionné précédemment, voire à partir d'une estimation réalisée au moyen d'un logiciel de simulation numérique.

Une étape supplémentaire peut être effectuée dans laquelle on met en contact la partie structurée 11, et plus précisément la portion centrale 20 et d'au moins une partie des bras tenseurs 30, avec la surface libre de la couche support 2. Pour cela, on peut immerger la partie structurée 11 dans une solution liquide, par exemple d'alcool ou d'eau déionizée acidifiée (pH proche de 2), puis on évapore le liquide. Lors de la phase d'évaporation, la partie structurée 11 suspendue vient naturellement au contact de la surface libre de la couche support 2. Il est alors possible de retirer par gravure une portion des bras tenseurs 30 distante vis-à-vis de la portion centrale 20, de manière à séparer ou individualiser la partie structurée 11 vis-à-vis de la partie périphérique 12.

Les figures 8A à 8C sont des vues de dessus, schématiques et partielles, de différentes variantes d'une membrane suspendue d'une structure semiconductrice 1 selon un mode de réalisation, dans lesquelles la portion centrale 20 est étirée de manière biaxiale par des bras tenseurs 30 de la membrane suspendue. Une telle structure semiconductrice 1 trouve une application dans le cadre d'un dispositif optoélectronique d'émission de lumière cohérence, tel qu'une diode laser. La portion centrale 20, et en particulier la ou les zones amincies 21, forme le milieu à gain de la diode laser. Dans ces exemples, deux bras tenseurs 30 en regard l'un de l'autre peuvent être dopées respectivement n+ et p+ pour ainsi assurer une injection électrique de porteurs de charge dans la portion centrale 20.

Comme l'illustre la figure 8A, la portion centrale 20 peut comporter une pluralité de zones amincies 21, distinctes les unes des autres, et distribuées spatialement de manière périodique pour former des cristaux photoniques. Les zones amincies 21 présentent ici une forme circulaire dans le plan XY, et l'ensemble de zones amincies 21 est disposé au centre X,Y=(o,o) de la portion centrale 20. Les cristaux photoniques peuvent présenter différentes géométries, par exemple une géométrie triangulaire, carrée, rectangulaire, hexagonale, etc. La période et les dimensions des zones amincies 21 peuvent être choisies de manière à obtenir à la fois une structure de bandes directe dans les zones amincies 21 et un bon recouvrement du mode optique avec le milieu à gain que forme la portion centrale 20. De par la présence des zones amincies 21, des barrières de potentiel sont présentes qui améliorent les propriétés optiques et/ou électroniques de la diode laser. En variante ou en complément, les zones amincies 21 peuvent également être présentes sur les bras tenseurs 30. Le taux de réflectivité peut être différent en direction de tel ou tel bras. Ainsi, un bras tenseur peut comporter moins de zones amincies 21 que les autres bras, diminuant ainsi la réflectivité et autorisant une transmission d'une partie du mode optique présent dans la portion centrale 20 en direction du bras tenseur concerné.

La figure 8B illustre une autre variante dans laquelle la cavité optique est formée par une pluralité de zones amincies 21.2, 21.3 en anneau qui entourent chacune une zone amincie 21.1 centrale. Dans cet exemple, une zone amincie 21.1 centrale est présente au milieu de la portion centrale 20, qui est entourée par au moins deux zones amincies 21.2, 21.3 en anneau. Une zone amincie 21.2, 21.3 en anneau est une portion de couche au moins partiellement gravée suivant son épaisseur, qui s'étend longitudinalement, ici de manière circulaire, autour d'un point central. Les zones amincies 21.1, 21.2, 21.3 peuvent présenter une épaisseur moyenne $e_{za}$ constante suivant l'axe longitudinal. Les épaisseurs moyennes des différentes zones amincies 21.1, 21.2, 21.3 peuvent être identiques ou différentes entre elles.

La figure 8C illustre une autre variante dans laquelle la cavité optique est longitudinale et délimitée par deux miroirs de Bragg (non représentés) formés dans deux bras tenseurs 30 en vis-à-vis et situés aux extrémités de zones amincies 21.4 et 21.5 qui s'étendent dans ces bras tenseurs. Ainsi, dans cet exemple, deux zones amincies 21.4, 21.5 latérales s'étendent de manière rectiligne sur la portion centrale 20 et les deux bras tenseurs 30 opposés. L'épaisseur moyenne des deux zones amincies 21.4, 21.5 et leur espacement sont choisis en fonction des propriétés optiques voulues. Ainsi, un mode optique peut être guidé longitudinalement grâce aux zones amincis 21.4 et 21.5 vers les deux miroirs de Bragg pour former une cavité optique. Il peut être avantageux de positionner une zone amincie 21.6 centrale dans la cavité optique, disposée ici entre les deux zones amincies 21.4, 21.5, de sorte que le maximum d'intensité du mode optique guidé recouvre une zone de la portion centrale 20, formée par la zone amincie 21.6 centrale, qui présente une structure de bandes directe.

Des modes de réalisation particuliers viennent d'être décrits. Différentes variantes et modifications apparaîtront à l'homme du métier.

Ainsi, les bras tenseurs 30 peuvent présenter une forme différente les uns aux autres, mais il est préférable qu'ils présentent une forme identique. La déformation en tension de la portion centrale 20 est au moins biaxiale et comporter pour cela quatre bras tenseurs 30 opposés deux à deux. Elle peut être en variante triaxiale, voire davantage, et comporter dans le cas triaxial trois bras teneurs opposés les uns aux autres par rapport à la portion centrale 20 ou six bras tenseurs 30 opposés deux à deux. Les bras tenseurs 30 sont de préférence répartis uniformément autour de la portion centrale 20.

**Revendications**

1. Structure semiconductrice (1), comportant une couche support (2) et une couche semiconductrice (10) réalisée en un composé semiconducteur cristallin, dont une partie de la couche semiconductrice (10) forme une membrane suspendue au-dessus d'une couche support (2), le composé semiconducteur cristallin étant choisi parmi les éléments de la colonne IV de la classification périodique et les alliages de ces éléments, parmi les alliages comportant des éléments des colonnes III-V de la classification périodique, et parmi les alliages comportant des éléments des colonnes II-VI de la classification périodique, la membrane suspendue étant formée :

    ◦ d'une portion centrale (20), contrainte en tension dans un plan parallèle à la couche support (2) ;
    ◦ de plusieurs portions latérales (30), opposées les unes aux autres vis-à-vis de la portion centrale (20), et agencées de manière à maintenir la portion centrale (20) suspendue et contrainte en tension suivant au moins deux axes distincts de déformation, les portions latérales (30) présentant une largeur moyenne supérieure à une largeur moyenne de la portion centrale (20), la largeur moyenne étant une dimension moyenne, dans un plan parallèle au plan de la couche support (2), suivant un axe transversal auxdits axes de déformation ;

    **caractérisée en ce que** la portion centrale (20) comporte au moins une zone amincie (21) en épaisseur.

2.   Structure semiconductrice (1) selon la revendication 1, dans lequel la zone amincie (21) présente un amincissement en épaisseur supérieur ou égal à 20%, et de préférence supérieur ou égal à 50%.

3.   Structure semiconductrice (1) selon la revendication 1 ou 2, dans lequel un rapport entre la surface de la zone amincie (21) et celle de la portion centrale (20) est supérieur ou égal à 14%, et de préférence supérieur ou égal à 25%.

4.   Structure semiconductrice (1) selon l'une quelconque des revendications 1 à 3, dans lequel la membrane suspendue présente une structure de bandes d'énergie directe au moins dans ladite zone amincie (21).

5.   Structure semiconductrice (1) selon l'une quelconque des revendications 1 à 4, dans lequel le composé semiconducteur cristallin est à base de germanium.

6.   Structure semiconductrice (1) selon l'une quelconque des revendications 1 à 5, dans lequel la portion centrale (20) comporte une pluralité de zones amincies (21) distinctes les unes des autres et agencées les unes par rapport aux autres de manière à former une cavité optique.

7.   Dispositif optoélectronique d'émission de lumière cohérente comportant une structure semiconductrice (1) selon la revendication précédente, la portion centrale (20) étant adaptée à former un milieu à gain du dispositif optoélectronique.

8.   Dispositif optoélectronique selon la revendication 7, dans lequel la portion centrale (20) comporte une pluralité de zones amincies (21) distinctes les unes des autres et disposées les unes à côté des autres de manière périodique de manière à former des cristaux photoniques.

9.   Dispositif optoélectronique selon la revendication 7, dans lequel la portion centrale (20) comporte une première zone amincie (21) entourée d'une pluralité de zones amincies (21) distinctes les unes des autres et présentant chacune une forme d'anneau entourant la première zone amincie (21), de manière à former une cavité optique en anneaux.

10.   Dispositif optoélectronique selon la revendication 7, dans lequel la portion centrale (20) comporte au moins deux zones amincies (21) sous la forme de bandes parallèles l'une à l'autre s'étendant longitudinalement sur la portion centrale (20) et sur deux portions latérales (30) disposées de manière opposée l'une à l'autre vis-à-vis de la portion centrale (20).

11.   Procédé de fabrication d'une structure semiconductrice 1 selon l'une quelconque des revendications 1 à 6, comportant les étapes suivantes :

    i. réalisation d'un empilement formé de la couche semiconductrice (10) recouvrant une couche sacrificielle (3) disposée sur une couche support (2), la couche semiconductrice (10) présentant une valeur initiale non nulle de contrainte en tension ;
    ii. structuration de la couche semiconductrice (10) de manière à former la partie structurée (11) et la partie périphérique (12) ;
    iii. réalisation d'au moins une zone amincie (21) en épaisseur dans la portion centrale (20) ;
    iv. réalisation d'une cavité (4) sous la partie structurée (11) en rendant libre une surface de la couche support (2) située en regard de la partie structurée (11), la portion centrale (20) étant alors contrainte en tension à une valeur finale supérieure à la valeur initiale.

12.   Procédé de fabrication selon la revendication 11, comportant au moins les étapes suivantes :

    - préalablement à l'étape i de réalisation de l'empilement, on estime une valeur minimale de contrainte en tension à partir de laquelle la zone amincie (21) de la portion centrale (20) présente une structure de bandes d'énergie directe pour une valeur donnée d'épaisseur moyenne de la zone amincie (21) ;
    - lors de l'étape i, réalisation de l'empilement de sorte que la couche semiconductrice (10) présente une valeur initiale inférieure à la valeur minimale ;
    - préalablement à l'étape ii de structuration, détermination de la structuration de sorte que, après l'étape iv de réalisation de la cavité (4), la zone amincie (21) de la portion centrale (20) présente une valeur finale de contrainte en tension supérieure ou égale à la valeur minimale, et donc une structure de bandes d'énergie directe.

**Patentansprüche**

1. Halbleiterstruktur (1), umfassend eine Trägerschicht (2) und eine Halbleiterschicht (10), die aus einer kristallinen Halbleiterverbindung hergestellt ist, wobei ein Teil der Halbleiterschicht (10) eine Membran bildet, die über einer Trägerschicht (2) aufgespannt ist, wobei die kristalline Halbleiterverbindung aus den Elementen der Spalte IV des Periodensystems und den Legierungen dieser Elemente, aus den Legierungen, die Elemente der Spalten III-V des Periodensystems umfassen, und aus den Legierungen, die Elemente der Spalten II-VI des Periodensystems umfassen, ausgewählt ist, wobei die aufgespannte Membran gebildet ist:

   ∘ aus einem Mittelabschnitt (20), der in einer Ebene parallel zur Trägerschicht (2) gespannt ist,
   ∘ aus mehreren Seitenabschnitten (30), die gegenüber dem Mittelabschnitt (20) einander gegenüberliegend sind und derart angeordnet sind, um den Mittelabschnitt (20) entlang mindestens zwei verschiedenen Verformungsachsen aufgehängt und unter Spannung zu halten, wobei die Seitenabschnitte (30) eine durchschnittliche Breite aufweisen, die größer als eine durchschnittliche Breite des Mittelabschnitts (20) ist, wobei die durchschnittliche Breite eine durchschnittliche Abmessung in einer Ebene parallel zur Ebene der Trägerschicht (2) entlang einer Achse ist, die quer zu den Verformungsachsen ist,

   **dadurch gekennzeichnet, dass** der Mittelabschnitt (20) mindestens einen in der Dicke verdünnten Bereich (21) aufweist.

2. Halbleiterstruktur (1) nach Anspruch 1, wobei der verdünnte Bereich (21) eine Verdünnung in der Dicke von größer als oder gleich 20 % und vorzugsweise von größer als oder gleich 50 % aufweist.

3. Halbleiterstruktur (1) nach Anspruch 1 oder 2, wobei ein Verhältnis zwischen der Oberfläche des verdünnten Bereichs (21) und jener des Mittelabschnitts (20) größer als oder gleich 14 % und vorzugsweise größer als oder gleich 25 % ist.

4. Halbleiterstruktur (1) nach einem der Ansprüche 1 bis 3, wobei die aufgespannte Membran mindestens in dem verdünnten Bereich (21) eine direkte Energiebandstruktur aufweist.

5. Halbleiterstruktur (1) nach einem der Ansprüche 1 bis 4, wobei die kristalline Halbleiterverbindung auf Germaniumbasis ist.

6. Halbleiterstruktur (1) nach einem der Ansprüche 1 bis 5, wobei der Mittelabschnitt (20) mehrere verdünnte Bereiche (21) aufweist, die voneinander verschieden sind und derart zueinander angeordnet sind, einen optischen Hohlraum zu bilden.

7. Optoelektronische Vorrichtung zur Emission von kohärentem Licht, umfassend eine Halbleiterstruktur (1) nach dem vorhergehenden Anspruch, wobei der Mittelabschnitt (20) geeignet ist, ein Verstärkungsmedium der optoelektronischen Vorrichtung zu bilden.

8. Optoelektronische Vorrichtung nach Anspruch 7, wobei der Mittelabschnitt (20) mehrere verdünnte Bereiche (21) aufweist, die voneinander verschieden sind und derart nebeneinander periodisch angeordnet sind, photonische Kristalle zu bilden.

9. Optoelektronische Vorrichtung nach Anspruch 7, wobei der Mittelabschnitt (20) einen ersten verdünnten Bereich (21) aufweist, der von mehreren verdünnten Bereichen (21) umgeben ist, die voneinander verschieden sind und jeweils eine Ringform aufweisen, die den ersten verdünnten Bereich (21) derart umgibt, einen ringförmigen optischen Hohlraum zu bilden.

10. Optoelektronische Vorrichtung nach Anspruch 7, wobei der Mittelabschnitt (20) mindestens zwei verdünnte Bereiche (21) in Form von Bändern aufweist, die zueinander parallel sind, die sich in Längsrichtung auf dem Mittelabschnitt (20) und auf zwei Seitenabschnitten (30) erstrecken, die gegenüber dem Mittelabschnitt (20) einander gegenüberliegend sind.

11. Verfahren zur Herstellung einer Halbleiterstruktur 1 nach einem der Ansprüche 1 bis 6, umfassend die folgenden Schritte:

   i. Erstellen eines Stapels, der aus der Halbleiterschicht (10) gebildet ist, die eine Opferschicht (3) bedeckt, die auf einer Trägerschicht (2) angeordnet wird, wobei die Halbleiterschicht (10) einen Anfangswert der Zugspannung, der nicht gleich null ist, aufweist,
   ii. Strukturieren der Halbleiterschicht (10) derart, den strukturierten Teil (11) und den peripheren Teil (12) zu bilden,

iii. Erstellen von mindestens einem in der Dicke verdünnten Bereich (21) im Mittelabschnitt (20),

iv. Erstellen eines Hohlraums (4) unter dem strukturierten Teil (11), indem eine Oberfläche der Trägerschicht (2), die dem strukturierten Teil (11) zugewandt angeordnet ist, freigemacht wird, wobei der Mittelabschnitt (20) dann auf einen Endwert, der größer als der Anfangswert ist, gespannt wird.

12. Verfahren zur Herstellung nach Anspruch 11, umfassend mindestens die folgenden Schritte:

- vor dem Schritt i des Erstellens des Stapels, Schätzen eines Mindestwerts der Zugspannung, ab dem der verdünnte Bereich (21) des Mittelabschnitts (20) eine direkte Energiebandstruktur für einen gegebenen Wert der mittleren Dicke des verdünnten Bereichs (21) aufweist,
- während des Schrittes i Erstellen des Stapels derart, dass die Halbleiterschicht (10) einen Anfangswert aufweist, der niedriger als der Mindestwert ist,
- vor dem Schritt ii des Strukturierens Bestimmen der Strukturierung derart, dass nach dem Schritt iv des Erstellens des Hohlraums (4) der verdünnte Bereich (21) des Mittelabschnitts (20) einen Endwert der Zugspannung, der größer als oder gleich dem Mindestwert ist, und somit eine direkte Energiebandstruktur aufweist.

## Claims

1. Semiconductor structure (1), including a carrier layer (2) and a semiconductor layer (10) made of a crystalline semiconductor compound, a portion of the semiconductor layer (10) of which forms a suspended membrane above a carrier layer (2), the crystalline semiconductor compound being chosen from elements of column IV of the periodic table of the elements and alloys of these elements, from alloys including elements of columns III-V of the periodic table of the elements, and from alloys including elements from columns II-VI of the periodic table of the elements, the suspended membrane being formed:

   ○ from a central segment (20), which is tensilely stressed in a plane parallel to the carrier layer (2); and
   ○ from a plurality of lateral segments (30), which are opposite one another with respect to the central segment (20), and arranged so as to keep the central segment (20) suspended and tensilely stressed along at least two separate deformation axes, the lateral segments (30) having an average width larger than an average width of the central segment (20), the average width being an average dimension, in a plane parallel to the plane of the carrier layer (2) along an axis that is transverse to said deformation axes;

**characterized in that** the central segment (20) includes at least one zone (21) of thinned thickness.

2. Semiconductor structure (1) according to Claim 1, wherein the thickness of the thinned zone (21) is thinned by 20% or more, and preferably 50% or more.

3. Semiconductor structure (1) according to Claim 1 or 2, wherein a ratio between the area of the thinned zone (21) and the area of the central segment (20) is higher than or equal to 14%, and preferably higher than or equal to 25%.

4. Semiconductor structure (1) according to any one of Claims 1 to 3, wherein the suspended membrane has a direct energy-band structure at least in said thinned zone (21).

5. Semiconductor structure (1) according to any one of Claims 1 to 4, wherein the crystalline semiconductor compound is based on germanium.

6. Semiconductor structure (1) according to any one of Claims 1 to 5, wherein the central segment (20) includes a plurality of thinned zones (21) that are separate from one another and arranged, with respect to one another, so as to form an optical cavity.

7. Optoelectronic device for emitting coherent light, including a semiconductor structure (1) according to the preceding claim, the central segment (20) being suitable for forming a gain medium of the optoelectronic device.

8. Optoelectronic device according to Claim 7, wherein the central segment (20) includes a plurality of thinned zones (21) that are separate from one another and placed beside one another periodically so as to form photonic crystals.

9. Optoelectronic device according to Claim 7, wherein the central segment (20) includes a first thinned zone (21) encircled by a plurality of thinned zones (21) that are separate from one another and that each have a ring shape encircling the first thinned zone (21), so as to form a ringed optical cavity.

10. Optoelectronic device according to Claim 7, wherein the central segment (20) includes at least two thinned zones (21) taking the form of strips that are parallel to one another and that extend longitudinally over the central segment (20) and over two lateral segments (30) that are placed opposite each other with respect to the central segment (20).

11. Process for fabricating a semiconductor structure (1) according to any one of Claims 1 to 6, including the following steps:

i) producing a stack formed from the semiconductor layer (10) covering a sacrificial layer (3) that is placed on a carrier layer (2), the semiconductor layer (10) having an initial non-zero tensile-stress value;
ii) structuring the semiconductor layer (10) so as to form the structured portion (11) and the peripheral portion (12);
iii) producing at least one zone (21) of thinned thickness in the central segment (20); and
iv) producing a cavity (4) under the structured portion (11) and thereby freeing a surface of the carrier layer (2) located facing the structured portion (11), the central segment (20) then being tensilely stressed with a final value higher than the initial value.

12. Fabricating process according to Claim 11, including at least the following steps:

- prior to step i of producing the stack, estimating a minimum tensile-stress value from which the thinned zone (21) of the central segment (20) has a direct energy-band structure for a given value of average thickness of the thinned zone (21 );
- in step i, producing the stack so that the semiconductor layer (10) has an initial value lower than the minimum value; and
- prior to the structuring step ii, defining the structuring so that, after step iv of producing the cavity (4), the thinned zone (21) of the central segment (20) has a final tensile-stress value higher than or equal to the minimum value, and therefore a direct energy-band structure.

**Fig.1A**

**Fig.1B**

**Fig.1C**

**Fig.2A**

**Fig.2B**

**Fig.2C**

## Fig.3A

## Fig.3B

## Fig.3C

**Fig.4**

**Fig.5A**      **Fig.5B**      **Fig.5C**

**Fig.6**

d=0,75µm        d=1µm        d=1,60µm

**Fig.7A**        **Fig.7B**        **Fig.7C**

**Fig.8A**

**Fig.8B**

**Fig.8C**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2960203 A

- EP 3151265 A

**Littérature non-brevet citée dans la description**

- **SÜESS et al.** Analysis of enhanced light emission from highly strained germanium microbridges. *Nature Photon,* 2013, vol. 7, 466-472
- **DE GASSENQ et al.** 1,9% bi-axial tensile strain in thick germanium suspended membranes fabricated in optical germanium-on-insulator substrates for laser applications. *Appl. Phys. Lett.,* 2015, vol. 107, 191904
- **NIQUET et al.** Onsite matrix elements of the tight-binding Hamiltonian of a strained crystal: Application to silicon, germanium, and their alloys,. *Phys. Rev. B,* 2009, vol. 79, 245201

- **DE REBOUD et al.** Structural and optical properties of 200 mm germanium-on-insulator (GeOI) substrates for silicon photonics applications. *Proc. SPIE 9367, Silicon Photonics X, 936714,* 27 Février 2015
- **JAN et al.** Tensile-strained germanium-on-insulator substrate for silicon-compatible optoelectronics. *Opt. Mater. Express,* 2011, vol. 1, 1121-1126